(19)

Europäisches
Patentamt
European
Patent Office
Office européen
des brevets

(11) **EP 2 562 745 B1**

(12) **EUROPEAN PATENT SPECIFICATION**

(45) Date of publication and mention
of the grant of the patent:
**13.02.2019 Bulletin 2019/07**

(51) Int Cl.:
*G10H 1/16* $^{(2006.01)}$     *G10H 3/18* $^{(2006.01)}$
*H04R 29/00* $^{(2006.01)}$

(21) Application number: **12005289.9**

(22) Date of filing: **19.07.2012**

(54) **Method and apparatus for impulse response measurement**

Verfahren und Vorrichtung zur Impulsantwortmessung

Procédé et appareil de mesure de réponse impulsionnelle

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **22.07.2011 GB 201112675**

(43) Date of publication of application:
**27.02.2013 Bulletin 2013/09**

(73) Proprietor: **Vainiala, Mikko Pekka
28900 Pori (FI)**

(72) Inventor: **Vainiala, Mikko Pekka
28900 Pori (FI)**

(74) Representative: **Norris, Timothy Sweyn
Basck
16 Saxon Road
Cambridge CB5 8HS (GB)**

(56) References cited:
**WO-A1-00/28521      CN-A- 101 426 169**

- **ANGELO FARINA: "Impulse Response
Measurements", 23RD NORDIC SOUND
SYMPOSIUM, BOLKESJO TOURIST HOTEL,
27-30 SEPTEMBER 2007, , 27 September 2007
(2007-09-27), pages 1-31, XP002590406,
Retrieved from the Internet:
URL:http://pcfarina.eng.unipr.it/Public/Pa
pers/238-NordicSound2007.pdf [retrieved on
2010-07-05]**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**FIELD OF THE INVENTION**

The present invention relates to methods of measuring impulse responses and for simulating such impulse responses, for example in respect of thermionic electron tube amplifiers and associated loudspeaker arrangements. Moreover, the present invention also concerns apparatus operable to implement aforementioned methods. Furthermore, the present invention also relates to software products recorded on machine readable media, wherein the software products are executable on computing hardware for implementing aforementioned methods.

**BACKGROUND OF THE INVENTION**

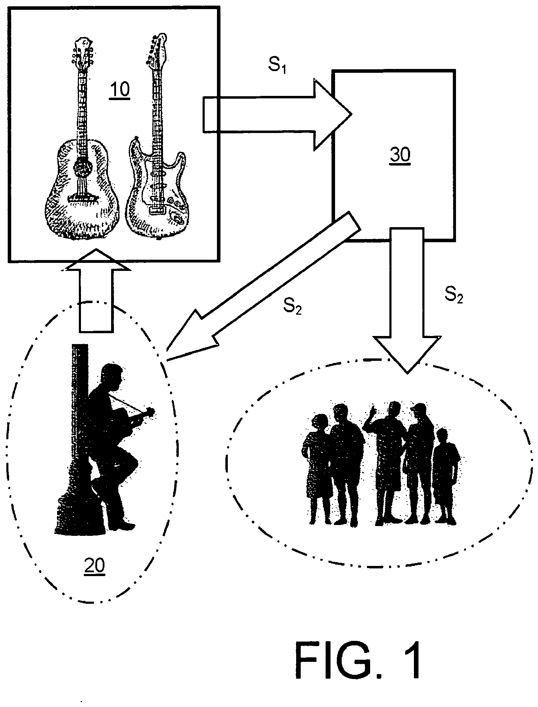

In respect of conventional acoustic musical instruments, as illustrated in FIG. 1, there is a sound source **10** under control of a musician **20,** wherein an output $S_1$ from the sound source **10** is conveyed via a coupling arrangement **30** to generate an acoustic output $S_2$ which is eventually appreciated as an acoustic sound by the musician **20** and potentially other persons listening to the acoustic output S2, for example an audience. The coupling arrangement **30** can be passive or active. "Active" corresponds to the output $S_1$ being subject to amplification to generate the acoustic output $S_2$.

An example of a passive implementation of the coupling arrangement 30 is a sound board of an acoustic piano; the sound source **10** in such case corresponds to a keyboard, a hammer mechanism, and a metal frame with piano "strings" stretched thereacross, wherein the keyboard receives from the musician **20** an input force via the keyboard to actuate the hammer mechanism to excite the "strings" into resonance to generate the output $S_1$. The coupling arrangement **30** implemented in a passive mode is beneficially analysed, namely represented, as a series of resonances $R_1$ to $R_n$. The resonances $R_1$ to $R_n$ have corresponding Q-factors $Q_1$ to $Q_n$, corresponding coupling coefficients $k_1$ to $k_n$, and corresponding centre frequencies $f_1$ to $f_n$. The resonances $R_1$ to $R_n$ are included within a frequency range of interest, for example 20 Hz to 20 kHz. Thus, the emitted sound $S_2$ is susceptible to being mathematically derived from the output $S_1$ by way of Equation 1 (Eq. 1):

$$S_2 = \sum_{i=1}^{n} k_i R_i S_1 \qquad\qquad \text{Eq. 1}$$

In practice, suitable selection of the resonances R and their associated resonant frequencies, together with the coupling coefficients k are vitally important when manufacturing a quality acoustic musical instrument, for example when constructing a quality grand piano or a quality acoustic guitar, because the coupling arrangement **30** causes distinct coloration of the output $S_1$ which enables the acoustic instrument to be recognized and appreciated by the musician **20** and potentially other persons listening to the acoustic output $S_2$. For accurately describing an acoustic instrument, the number n of resonances R employed in Equation 1 (Eq. 1) can be potentially very large, for example several hundred to several thousands.

In a high-fidelity sound reproduction system, the sound source **10** is, for example, a CD player including a high-quality DAC output or similar to generate the output $S_1$, and the coupling arrangement **30** is implemented as an amplifier arrangement coupled to a loudspeaker arrangement and is carefully designed to be as accurate as possible so that the acoustic output $S_2$ is as faithful a reproduction of the output $S_1$ as technically possible. Special measures, for example use of electrostatic speakers and class-A solid-state linear amplifiers, are sometimes employed to achieve most accurate sound reproduction in top quality high-fidelity sound reproduction systems.

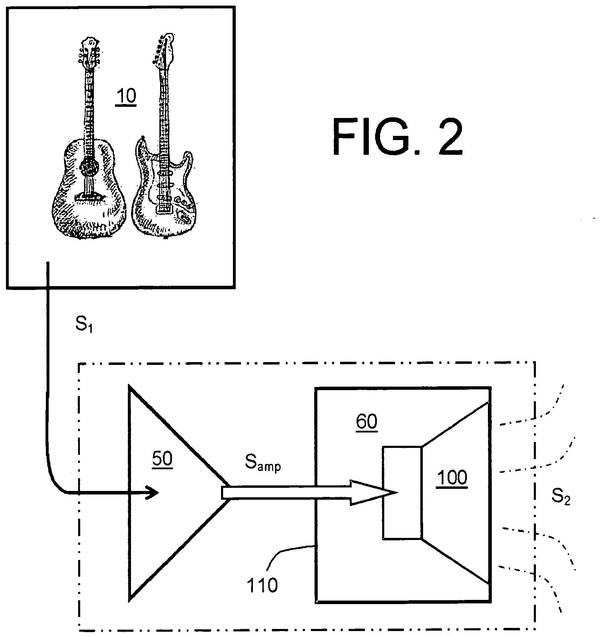

Another example of an active implementation of the coupling arrangement **30** is a thermionic electron tube amplifier **50** with an associated loudspeaker arrangement **60** as illustrated in FIG. 2. The thermionic electron tube amplifier **50,** also known as a "valve" amplifier, is arranged in operation to receive an electrical signal as the output $S_1$ from a pickup of an electric guitar **10,** and to amplify the output $S_1$ to generate a corresponding acoustic output $S_2$ from the loudspeaker arrangement 60. Well known commercial companies such as Marshall Amplification (United Kingdom), Peavey (United States of America), Fender (United States of America) manufacture such active sound amplification apparatus, although there are many alternative manufacturers of active sound amplification apparatus in the World competing for market share; "Marshall", "Peavey" and "Fender" are registered trademarks (RTM). Musicians skilled in playing electric guitars contemporarily greatly enjoy employing valve amplifiers and associated loudspeaker arrangements for generating the acoustic output $S_2$. Such enjoyment derives from considerable sound colouration introduced in operation by such valve amplifiers and associated loudspeaker arrangements. When sound colouration occurs, the coefficients k and Q-factors Q of the resonances R in Equation 1 (Eq. 1) are contemporarily perceived to vary considerably over the frequency range of interest.

Certain constructions of the loud speaker arrangement **60,** namely including one or more loudspeaker driver units **100,** referred to as "drivers", and their associated one or more cabinets **110,** have certain distinctive sound coloration characteristics. In contradistinction, in the case of high-fidelity apparatus, it is desirable that the sound coloration should be small as possible. The distinctive sound colouration characteristics are potentially influenced by one or more of following factors:

(a) a physical shape and size of the one or more cabinets **110;**
(b) a material from which the one or more cabinets **110** are fabricated, whether or not a volume enclosed by walls of the one or more cabinets **110** are at least partially filled with sound absorbing materials, whether or not the walls of the one or more cabinets **110** present the volume with irregular surface topology or one or more planar surfaces, and whether or not the one or more cabinets **110** are of a back-vented configuration or infinite-baffle closed construction;
(c) a material from which diaphragms of the one or more loudspeaker driver units **100** are manufactured, a geometrical shape of the diaphragms" and an elasticity of their spider mounts and roll surrounds which are employed to centre and support the diaphragms; and
(d) a manner in which the one or more loudspeaker driver units **100** are spatially disposed in the one or more cabinets **110.**

For example, it is conventional practice to construct the one or more cabinets **110** from solid wood, plywood, medium density fibre board (MDF) or chipboard panels which are at least partially filled with acoustic wadding, and the one or more driver units **100** are manufactured with diaphragms manufactured from stiffened impregnated paper or cloth. Occasionally, more exotic materials such as Titanium, Kevlar or Carbon fibre are employed for fabricating the diaphragms; "Kevlar" is a registered trade mark (RTM).

It has become contemporary practice to provide musicians with a musician-selectable simulation, namely synthesis or emulation, of different amplification system colorations in their sound amplification equipment; for example, such selection is contemporarily provided as a user-selectable option by way of a rotatable switch or equivalent on amplifier units. These simulations, namely amplifier emulations, are optionally provided for example in a context of "combo units" wherein the valve amplifiers **50** and the one or more loudspeaker driver units **100** are housed together as integrated apparatus. These emulations may alternatively be implemented via processing software when processing recorded signals for producing musical products such as compact discs (CD) and sound files for subsequent distribution to customers. The musicians are thereby able to select between supposedly different types of loudspeaker arrangements and associated thermionic electron tube amplifiers to achieve a desired musical effect, namely sound colouration, for example in response to an epoch of music being performed. It is contemporary practice that the simulations be conventionally derived from a measurement and associated analysis of an input signal, equivalent to the output $S_1$, to a thermionic electron tube ("valve") amplifier and a corresponding acoustic output, equivalent to the acoustic output $S_2$, from a speaker arrangement coupled to the amplifier, wherein the acoustic output $S_2$ is measured using a high quality microphone which is conventionally assumed to be substantially devoid of colouration effects; by analyzing the acoustic output derived from the microphone relative to the input signal $S_1$ to the valve amplifier by way of an impulse pulse response and/or a swept frequency response and performing a form of mathematical processing, for example a convolution or de-convolution, pursuant to Equation 1 (Eq. 1), it is feasible to provide aforesaid simulations, namely emulations. However, such an approach often does not provide a sufficiently accurate simulation, namely synthesis or emulation, in view of highly complex sound colouration process which occur in practice for a whole variety of reasons.

Contemporary combo amplifiers typically include an amplifier unit and one or more loudspeakers within a housing. Typically, the amplifier unit is usually implemented using thermionic electron tubes and/or analogue solid-state devices for providing signal amplification. Moreover, contemporary amplifier emulators attempt to simulate a sound of valve amplifiers or solid-state amplifiers using digital signal processing (DSP) and/or solid-state circuits. The emulators are often implemented in a contemporary context using software executable upon computing hardware. However, musicians find that contemporary simulation, namely emulations, are not sufficiently realistic and representative, despite contemporarily great care being taken when measuring characteristics of sound amplification systems

In a published international PCT application no. WO 00/28521 (PCT/GB99/03753, *"Audio dynamic control effects synthesiser with or without analyse",* Sintefex Audio LDA), there is described a method and apparatus for applying a gain characteristic to an audio signal. Data storing a plurality of gain characteristics at a plurality of different levels is stored in data storage means. The amplitude of an input signal is repeatedly assessed and from this a gain characteristic to be applied to the input is determined.

In a published Chinese patent application CN101426169A ("*Time-domain tracking filter fast detecting acoustic response parameter of sounding body and system",* JIAXING ZHONGKE ACOUSTIC TECHN), there is described a method and system for applying a time-domain tracking filter technique in a conventional audio measurement unit for measuring the audio response parameter of a sound producer. The aforementioned implementation adopts a special signal to excite the sound producer to be tested; after testing the voltages at both ends of the sound producer and the sound pressure signals, the aforementioned implementation can use the time-domain tracking filter to track the base frequency variation in the audio response; the aforementioned implementation can obtain various audio response parameter results curve such as base frequency response, each harmonic response, total harmonic distortion + noise response, total harmonic distortion response and the like by processing such as equivalent low pass filtering, band-pass filtering, band elimination filtering, high-pass filtering and the like. The aforementioned implementation has superiority which lies in that it can separate and obtain the base frequency and sub-frequency response in the audio response of the sound producer to be tested in a short time based on the time-domain, which can greatly enhance the test efficiency to the audio response parameter of the sound producer in the R&D stage and the quality management stage. However, the aforementioned implementation does not enable to measure independently the impulse response of the sound producer and the impulse response of the amplifier connected to the sound producer.

## SUMMARY OF THE INVENTION

The present invention seeks to provide an improved method of measuring an impulse response, for example an impulse response of a combination of a thermionic electron tube ("valve") amplifier and a loudspeaker arrangement.

According to a first aspect of the present invention, there is provided a method of measuring an impulse response as claimed in claim 1.

The invention is of advantage in that it enables an impulse response of the amplifier and the loudspeaker arrangement to be measured independently and more accurately, thereby generating more representative impulse responses, for example for use in subsequent synthesis, namely simulation or emulation.

Optionally, the signal processing operation includes at least one of: a convolution, a de-convolution, a frequency-domain analysis, a Fast-Fourier transform (FFT) or other mathematical operation.

Optionally, the method includes employing the test signal generator ($S_{WP}$) to apply a sweep frequency signal and/or a broad band test signal comprising a simultaneous plurality of signal components. More optionally, the method includes driving the amplifier at a plurality of power output levels in the acoustic output ($S_2$), and determining the impulse response in respect of each of the plurality of power output in the acoustic output ($S_2$).

Optionally, the method is implemented, such that the signal processing operation is a convolution which is performed using at least one of:

(a) time-domain convolution;
(b) Fast Fourier Transform (FFT) and/or Inverse Fast Fourier Transform (I FFT); and
(c) one of more physical models describing transfer characteristics of active components present in the amplifier and/or the speaker arrangement.

Optionally, two sets of measurements are made when implementing the method including:

(i) applying a sweep signal ($S_1$) into the amplifier coupled at its output to the loudspeaker arrangement and measuring the acoustic output (S2) from the loudspeaker arrangement for generating a first sample for the digital signal processing arrangement (DSP); and
(ii) applying a dummy load to the amplifier in substitution for, or in addition to, the loudspeaker arrangement, applying the sweep signal ($S_1$) to the amplifier and measuring a second sample from the dummy load for the digital signal processing arrangement (DSP); and
(iii) processing the first and second samples for identifying individual signal colouration contributions corresponding to the amplifier and the load speaker arrangement.

According to a second aspect of the invention, there is provided an apparatus for measuring an impulse response as claimed in claim 6.

It will be appreciated that features of the invention are susceptible to being combined in various combinations without departing from the scope of the invention as defined by the appended claims.

## DESCRIPTION OF THE DIAGRAMS

FIG. 1: is an illustration of a representation of a conventional musical instrument including an active or passive coupling arrangement;
FIG. 2: is an illustration of an active implementation of the musical instrument in FIG. 1 utilizing a thermionic valve amplifier coupled to an associated loudspeaker arrangement;

FIG. 3: is an illustration of an arrangement of apparatus not falling within the scope of the appended claims for simulating, namely synthesizing or emulating, an impulse response without needing to drive a loudspeaker arrangement;

FIG. 4: is an illustration of a configuration of apparatus for measuring an impulse response of an amplifier and its associated loudspeaker arrangement;

FIG. 5: is an illustration of an arrangement of apparatus pursuant to the present invention for measuring an impulse response of an amplifier and its associated loudspeaker arrangement;

FIG. 6: is a circuit diagram of a dummy amplifier load for use when implementing the apparatus of FIG. 5;

FIG. 7: is an illustration of a thermionic electron tube amplifier provided with an impulse synthesis functionality for enabling the amplifier to simulate various amplifier-speaker combinations whose impulse responses have been earlier measured and subsequently used in FIG. 7 for providing the functionality;

FIG. 8: is an illustration of an example of a thermionic valve amplifier combo with integrated speaker and including impulse response simulation functionality;

FIG. 9: is an illustration of an alternative measuring set-up for measuring a first signal A based on a combination of an amplifier, a microphone arrangement and a loudspeaker arrangement;

FIG. 10: is an illustration of a further alternative measuring set-up for measuring a second signal B based on a combination of the amplifier in FIG. 8 and a dummy load coupled to the amplifier; and

FIG. 11: is an illustration of devices for storing impulse sounds.

In the accompanying diagrams, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

## DESCRIPTION OF EMBODIMENTS OF THE INVENTION

In overview, aforementioned conventional approaches to providing sound simulation, namely synthesis or emulation, as described in the foregoing seek initially to measure tonal colouration caused by acoustic or electrical systems and to express such tonal colouration using, for example, one or more impulse responses. The one or more impulse responses are then subsequently used for processing uncoloured sound signals to generate a simulation, namely a synthesis or emulation, of an expected acoustic output that would result from such signals being applied to the acoustic or electrical systems whose one or more impulse responses have been determined. The one or more impulse responses are thus useable in sound simulation apparatus and software for processing signals to provide user-desired colouration effects pursuant to the measured one or more impulse responses.

An impulse response represents a system's response to an impulse signal input applied to the system. For an acoustic system, for example an acoustic system represented by reverberation in a concert hall, the impulse input signal can be represented by a sound of a start pistol, and an impulse response is then represented as a resonance characteristic of corresponding reverberant sounds of the start pistol recorded in the hall after the start pistol has been fired. The impulse response represents effectively an acoustic signature of the acoustic system.

In practice, it is often not practical to measure an impulse response of a system by employing an impulse signal because such an approach often results in an unsatisfactory signal-to-noise ratio in the resulting measured impulse response, especially when the system has a limited dynamic range. The impulse response is often better measured using a broadband frequency excitation into the acoustic or electrical system. When employing such broadband frequency excitation, the impulse response can be determined using a mathematical processing method, for example a de-convolution, between the input signal applied to the system and the corresponding acoustic output signal provided from the system. Once determined by such de-convolution, the impulse response can be applied to signals to simulate, namely emulate, the acoustic or electrical system as aforementioned. Conveniently, measurement of the impulse response is referred to as being an analysis-phase, and subsequently applying the impulse response to some signal to synthesize a corresponding acoustic output signal is referred to as being a synthesis-phase. In a first respect, the present invention is concerned with methods and apparatus for performing the analysis-phase. Moreover, in a second respect, the present disclosure is concerned with methods and apparatus for performing the synthesis-phase.

The inventors of the present invention have appreciated that such a conventional impulse response pertains to a system which is assumed to be linear, namely to systems which do not cause significant distortion of signals transmitted therethrough. In practice, this means that conventional impulse response methods, for example contemporarily providing user-selectable speaker simulations in proprietary "combo" valve amplifier units or loudspeaker simulation systems, provide an unsatisfactory simulation of real guitar valve amplifiers and associated loudspeakers; real guitar amplifiers and associated speakers cause highly complex sound modification for a variety of reasons. Such highly complex sound modification will now be elucidated and is not contemporarily sufficiently appreciated by persons skilled in the art of impulse response measurement and simulation in respect of sound reproduction systems.

Thermionic electron tubes, also known as "valves", are often employed as active signal amplifying elements in guitar amplifiers, for example in loudspeaker-driving output stages operating in class A mode, or alternatively in class AB mode when higher output power are required. Such electron tubes have a transfer characteristic of anode current as a function of grid voltage which is non-linear in nature, but typically is susceptible to being presented by a high-order polynomial or logarithmic-type mathematical function, for example embodying the conventionally known Dushmann equation of voltage-current transfer characteristics of an electron tube. Moreover, such thermionic electron tubes are required to operate at relatively high excitation potentials of several hundred volts which are generally not directly compatible with loudspeakers having corresponding coil impedances in an order of 3 to 16 Ohms and requiring significant drive currents of several amperes when in operation. It is thus conventional practice to employ magnetic matching transformers between output electron tubes of an electron tube power amplifier, for example KT66 or EL34 proprietary valve types, and one or more loudspeakers coupled to the output of the electron tube amplifier. On account of complex high frequency electrical resonances that magnetic output transformers are susceptible to exhibiting together with a relatively low response pole exhibited by such thermionic electron tubes when implemented as triodes, it is conventional practice to employ a relatively low forward gain in the thermionic tube amplifiers with corresponding low degrees of negative feedback around such amplifiers to define their overall amplification gain. A consequence of such an approach is that such valve amplifiers exhibit non-linearity characteristics in their gain response from their input to their output, whilst potentially low levels of transient intermodulation distortion (TID). Moreover, the aforesaid magnetic matching transformer employed to couple from one or more output electron tubes to the one or more loudspeakers is itself a non-linear component as a result of magnetic saturation effects that arise therein during operation when driven with large-amplitude signals. Such non-linear effects result in signal energy cross-coupling between the resonances R in Equation 1 (Eq. 1) which is not properly taken into account in contemporary impulse response simulations; the non-linearity results in subtle frequency multiplication of input signals as described in Equation 2 (Eq. 1):

$$S_{amp} = \sum_{j=1}^{m} A_j \sin\left(j\omega t + \theta_j\right) \qquad \text{Eq. 2}$$

wherein

$S_{amp}$ = output signal from the electron tube amplifier driving the one or more loudspeakers;
$S_1 = A_0 \sin \omega t$, namely input signal to the electron tube amplifier;
$A$ = amplification coefficient;
$\omega$ = input signal angular frequency;
$t$ = time;
$\theta$ = relative phase angle of $j^{th}$ harmonic in the output driving the one or more loudspeakers; and
$m$ = a highest order of harmonic content generated by the electron tube amplifier.

In Equation 2 (Eq. 2), the coefficients A, and also potentially the angles θ, change depending upon an amplitude of the input signal and the amplifier gain selected by the user, in other words the output signal $S_{amp}$.

The output signal $S_{amp}$ is then itself employed to drive one or more loudspeakers to generate the aforementioned acoustic output $S_2$. However, a loudspeaker is itself a complex electromagnetic mechanical device despite its seemingly simple form of construction. By way of movement of a voice coil of the loudspeaker, especially when the loudspeaker is relatively efficient as is often a case for guitar combo amplifiers, the coil generates back e.m.f.'s due to loudspeaker diaphragm movement which is coupled back via the aforementioned transformer into the one or more output electron tubes of the amplifier and also influences a negative feedback network of the amplifier; this can subtly influence coupling between the resonances R in Equation 1 (Eq. 1). Moreover, it is conventional practice for guitarists to play their guitars with their corresponding valve amplifiers turned up to near full volume which results in considerable physical movement of one or more diaphragms of the one or more loudspeakers reproducing sounds generated by the guitarists' instruments; the diaphragms are required simultaneously to reproduce a broad spectrum of signal components which means that large diaphragm excursions needed for reproducing lower frequency signal components results in Doppler shift modulation being applied by the lower frequency signal components to higher frequency signal components, namely high-frequency "tizzying" effects, for example in a manner as described in Equation 3 (Eq. 3):

$$S_2 = \sum_{l=1}^{p} \sum_{h=1}^{q} B_{l,h} \sin\left(\omega_l t + \theta_l + D_{l,h} \sin\left(\omega_h t + \theta_h\right)\right)$$
<div align="right">Eq. 3</div>

wherein

$B_{l,h}$ = loudspeaker coupling coefficient;
$p$ = index defining signal component;
$q$ = index defining signal component;
$\omega_l$ = higher frequency signal component;
$\omega_h$ = lower frequency signal component;
$D_{l,h}$ = Doppler frequency shift coefficient which is a function of the amplitude of the signal $S_2$;
$\theta_l$ = relative phase of signal component having angular frequency $\omega_i$; and
$\theta_h$ = relative phase of signal component having angular frequency $\omega_h$.

The Doppler shift is often perceived as a blurring effect which simultaneously adds a perceived "depth" to the sound reproduced.

In addition to Doppler effects described in Equation 2 (Eq. 2), referring to FIG. 2, the one or more cabinets **110** and the one or more loudspeaker drivers **100** will each also result in colouration pursuant to Equation 1 (Eq. 1), for example due to various subsidiary Eigenmodes in vibration patterns of conical diaphragms of the one or more drivers **100** as well as cavity resonances within an inner volume of the one or more cabinets **110,** as well as Eigenmodes of structural resonance of the one or more cabinets **110.**

From the foregoing, it will be appreciated that an accurate simulation, namely synthesis, of an acoustic output $S_2$ of a thermionic electron tube amplifier **50** coupled to one or more loudspeakers **110** when driven by an output signal $S_1$ of an electric guitar is a very highly complex challenge in view of complex and subtle colourations in the acoustic output $S_2$, especially when such complex and subtle colourations are also a function of an amplitude of the acoustic output $S_2$. Guitarists greatly enjoy such complex and subtle sound colouration because it provides fullness and excitement in the acoustic output $S_2$ relative to the signal $S_1$. Moreover, the sound colouration increases as the amplifier **50** is driven increasingly towards saturation, namely "soft" clipping; solid-state amplifiers often exhibit "hard" clipping which is perceived quite differently by guitarists. Some guitarists even enjoy the acoustic output $S_2$ when clipping occurs at the amplifier **50,** wherein the amplifier **50** becomes significantly non-linear in its amplification characteristics; such clipping is for example much appreciated in vintage Hammond B3 tone-wheel organs provided with valve amplification. The colouration associated with Equations 2 and 3 (Eq. 2 and Eq. 3) results in complex signals in the acoustic output $S_2$ which the human brain finds challenging and interesting. Even the one or more drivers **100** can exhibit mechanical non-linearity as their diaphragms are instantaneously displaced to a limit of movement of their roll-surrounds and coil spider mounts, namely are subject to a mechanical form of signal clipping.

Contemporary impulse response simulations of the amplifier **50** coupled to the loudspeaker arrangement **60** based solely upon the application of Equation 1 (Eq. 2) represents a gross oversimplification of complex signal colouration processes which occur in practice as elucidated in the foregoing. Moreover, the amplifier **50** dynamically mutually interacts with the loudspeaker arrangement **60** such that dummy resistive loads applied to the amplifier **50** in substitution for the loudspeaker arrangement 60 will cause the amplifier **50** to function in a non-representative manner; this is a frequent oversight in conventional approaches of simulation, namely synthesis or emulation. A dummy resistive load, for example, does not exhibit dynamic inertial movement which the one or more diaphragms of the one or more drivers **100** exhibit when in operation.

In order to further elucidate the present invention, approaches to measure an impulse response of the valve amplifier **50** and loudspeaker arrangement **60** of FIG. 2 will be described, which will then be juxtaposed to alternative methods pursuant to the present invention.

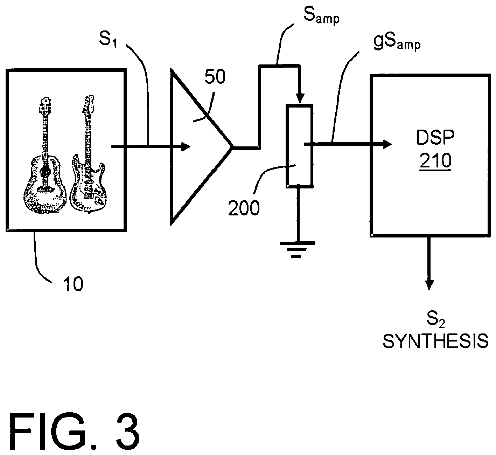

An artificial load **200** is illustrated in FIG. 3, conveniently implemented as a simple circuit including resistive elements, coupled to an output $S_{amp}$ of a valve amplifier **50**. A portion of the signal $S_{amp}$, for example derived from a resistive potential divider included in the artificial load **200,** is provided to a digital signal processing circuit board (DSP) **210**. The DSP board **210** contains a library of pre-recorded impulse responses from several loudspeaker-microphone combinations. When performing synthesis, the DSP board **210** is operable to transform the signal $gS_{amp}$ to make it sound as though it had been generated by a loudspeaker arrangement **60** coupled to the valve amplifier **50,** namely is capable of synthesizing, namely emulating, the acoustic output $S_2$. In other words, the artificial load **200** is beneficially employed instead of a loudspeaker arrangement **60** when implementing an emulation, namely synthesis. Such emulation enables, for example, recording to be performed without needing to generate high acoustic sound intensities.

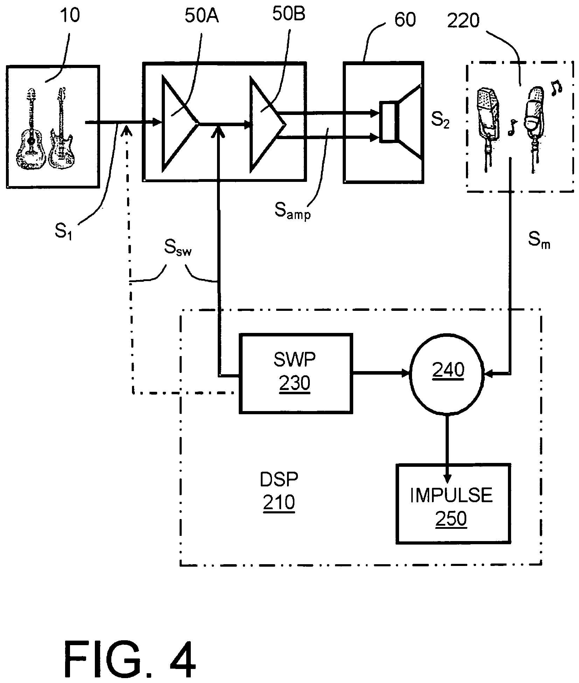

Generation of the pre-recorded impulse responses will now be elucidated with reference to FIG. 4; this corresponds to the aforesaid analysis-phase.

In FIG. 4, a guitar **10** is coupled to a "valve" amplifier **50** including a pre-amplifier stage **50A** and a power amplifier stage **50B;** the power amplifier stage **50B** is implemented using thermionic electron tubes, namely "valves". The "valve" amplifier **50** is coupled to a loudspeaker arrangement **60** including one or more loudspeakers. In such an arrangement in FIG. 4, playing the guitar **10** results in generation of the acoustic output $S_2$.

A microphone arrangement **220** including one or more microphones, for example high-quality condenser microphones, is coupled to the DSP board **210** and placed in a position to receive the acoustic output $S_2$ generated from the loudspeaker arrangement **60**. The microphone arrangement **220** is a high quality apparatus which is preferably operable to provide a low degree of sound colouration for signals transduced therethrough, although some colouration therethrough will occur in practice; spatial positioning of the microphone arrangement **220** relative to the loudspeaker arrangement 60 is also a colouration-influencing factor, as well as a preamplifier employed in conjunction with the microphone arrangement **220**. The DSP board **210** includes a sweep generator (SWP) **230** for injecting a sweep signal Ssw between the pre-amplifier stage **50A** and the power amplifier stage **50B** as illustrated; conveniently, an effects-loop return jack connection of the amplifier **50** is employed for inputting the sweep signal Ssw to the amplifier **50B.** An example of the sweep signal $S_{sw}$ is a sinusoidal signals whose frequency is temporally swept from 80 Hz to 8 kHz, or a combination of a plurality of such swept sinusoidal signals. Whereas a single swept sinusoidal signal allows for propagation delays and resonances to be determined, a plurality of such swept sinusoidal signals allows for signal interaction effects, for example Doppler colouration, to be measured also. Beneficially, the sweep signal $S_{sw}$ is input either at an input to the power amplifier stage **50B** or it can be input at a guitar input to the pre-amplifier stage **50A** when a connection point between the amplifiers **50A, 50B** is not accessible.

When executing a method of determining an impulse response of an arrangement as illustrated in FIG. 4, the sweep signal $S_{sw}$ is applied, for example, to the power amplifier **50B** which correspondingly is used to drive the loudspeaker arrangement **60** and generate a corresponding microphone signal $S_m$ representative of the acoustic output $S_2$. The sweep signal $S_{sw}$ is usually a sinusoidal signal, or a concurrent plurality of such sinusoidal signals, which is temporally swept in frequency during a period of time in which data is collected at the DSP board **210**. A de-convolution **240,** or alternative mathematical function for providing impulse response analysis, is then applied to the data representative of the sweep signal Ssw and the corresponding acoustic output $S_2$ as represented by the microphone signal $S_m$ to determine an impulse response **250** representative of the valve amplifier 50 and the speaker arrangement **60** and also that of the microphone arrangement **220**. The impulse response **250** is, for example, a data set of parameters; the set of parameters can be used in conjunction with software executing on the DSP board **210** to provide a simulation, namely synthesis or emulation of the impulse response **250,** namely when executing the aforementioned synthesis-phase.

It will be appreciated from the method executed in respect of FIG. 4 that the measured impulse response **250** contains substantially a combined acoustic fingerprint of all system parts substantially between the sweep generator (SWP) **230** and the microphone arrangement **220,** more strictly all elements included between the signals $S_{sw}$ and $S_m$ in FIG. 4. On account of the amplifier **50** adding sound coloration in addition to the speaker arrangement **60,** the impulse response **250** determined using the method is non-representative of, for example, solely the loudspeaker arrangement **60** and the microphone arrangement **220**. Moreover, use of a single swept frequency for the sweep signal $S_{sw}$ does not enable colouration of the speaker arrangement **60** caused by intermodulation Doppler effects to be properly characterized. Thus, contemporary approaches represent merely a crude approximation for an impulse response. However, If the impulse response **250** determined by the DSP **210** is then employed subsequently in another amplifier-loudspeaker combination to simulate user-selectively an alternative type of system, the colouration due to a valve amplifier **50** is effectively added twice, creating a non-representative final acoustic effect. The present invention provides a solution to double inclusion of amplifier characteristics when executing the synthesis-phase.

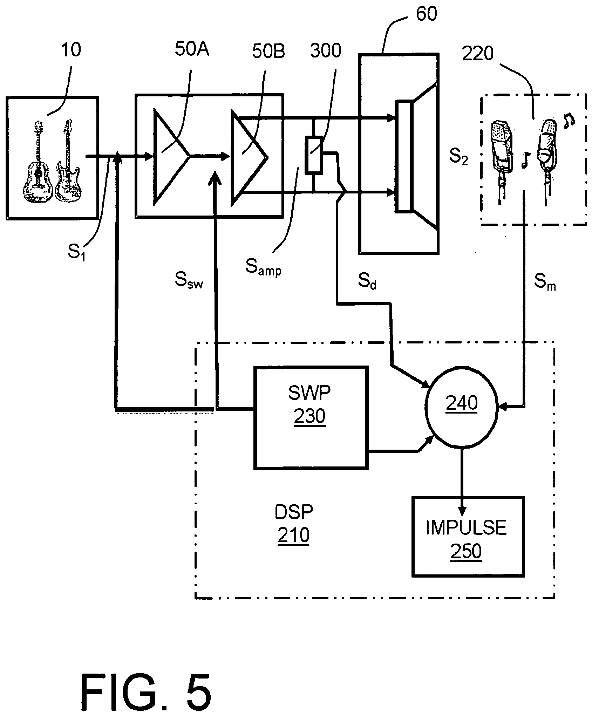

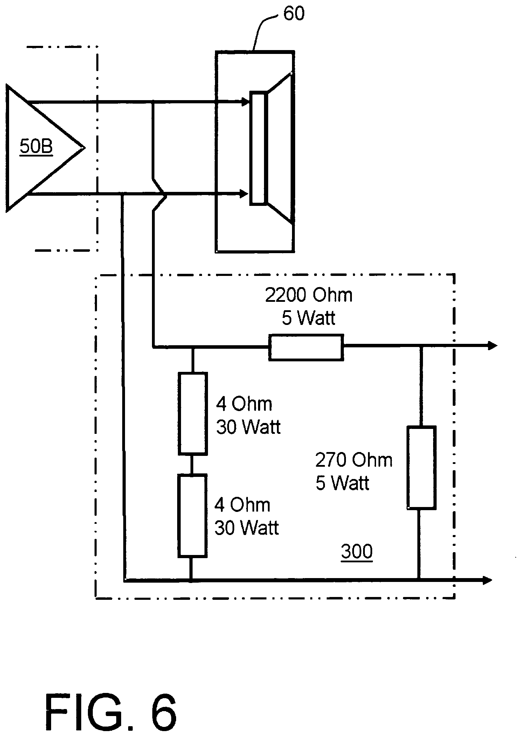

Whereas FIG. 4 which represents a simpler approach to measure impulse response, the present invention more preferably employs an arrangement as illustrated in FIG. 5. The arrangement in FIG. 5 is similar to that in FIG. 4 with a modification that a dummy resistive load **300** is coupled in parallel with the loudspeaker arrangement **60** or in place of it, to provide a signal $S_d$ to the DSP board **210** in combination with the aforementioned microphone arrangement $S_m$ signal. The DSP board **210** is operable to generate the sweep signal $S_{sw}$ as before for feeding into the power amplifier 50B. Moreover, the sweep signal $S_{sw}$ is beneficially inserted into a guitar input of the amplifier **50** when of a "vintage" type wherein a connection point to a point between the preamplifier **50A** and the power amplifier **50B** is not available or accessible. Conveniently, the dummy resistive load **300** is implemented as depicted in FIG. 6. Optionally, the dummy load **300** includes reactive components wherein the dummy load **300** is varied in its impedance characteristics depending upon which loudspeaker simulation is to be selected.

In Fig. 5, the de-convotution **240** or other signal processing operation is performed between the output of the amplifier $S_{amp}$ driving the loudspeaker arrangement **60** and the microphone arrangement signal Sm. In consequence, when the swept signal $S_{sw}$ is applied, only the impulse response of the speaker arrangement **60** and the microphone arrangement **220** is derivable from the signals $S_d$ and $S_m$, whereas an overall impulse response of the amplifier **50** and the speaker arrangement **60** is derivable from the signals $S_{sw}$ and $S_m$. Optionally, the impulse response of solely the amplifier is derivable from the signals $S_{sw}$ and $S_d$ in representative operating conditions, namely the amplifier **50** is driving a real electromagnetic inertial load represented by the one or more drivers **100** of the loudspeaker arrangement **60.** On account of the method of the present invention, for example implemented in respect of an arrangement of apparatus as illustrated in FIG. 5, the impulse response **250** obtained from the signals $S_m$ and $S_d$ in relation to the swept signal $S_{sw}$ represents extremely well the behaviour of the loudspeaker arrangement 60 and the microphone arrangement **220.** The inventors of the present invention have found from informal listening tests that it is virtually impossible to distinguish simulated, namely synthesized, sounds generated using the impulse response **250** from real studio-recorded guitar sounds. In other words, the present invention is capable of providing improved synthesis, namely emulation, during the aforementioned synthesis-phase.

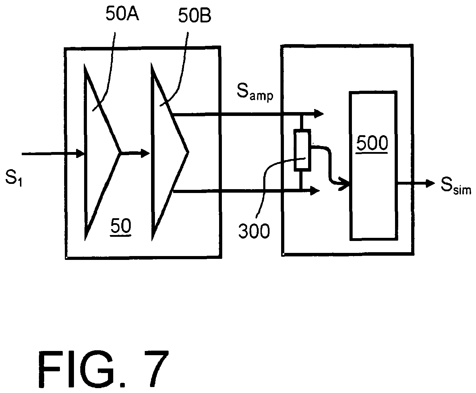

The impulse response **250** can be employed in a simulation, namely synthesis, arrangement as illustrated in FIG. 7; this corresponds to the aforementioned synthesis-phase. The arrangement in FIG. 7 employs the amplifier **50,** but its loudspeaker arrangement **60** is disconnected. This is beneficial to do when it is desired not to generate a considerable acoustic output as occurs when the valve amplifier **50** is driven to function in combination with the loudspeaker arrangement **60** in a regime approaching clipping with large excursions of diaphragms of one or more drivers **100** in the loudspeaker arrangement **60.**

In FIG. 7, the musician **10** couples his/her guitar to the amplifier **50** and an output $S_{amp}$ of the amplifier **50** is not fed to the loudspeaker arrangement **60,** but rather solely to the dummy load **300** to generate the signal $S_d$ which is fed via a convolution **500** or other signal processing operation provided with the impulse response **250** derived in FIG. 5 from the signals $S_d$ and $S_m$ to generate a simulated output $S_{sim}$ in FIG. 7. $S_{sim}$ is an accurate representation of $S_2$ in FIG. 5, but without a need to generate vast amounts of acoustic energy from the speaker arrangement 60. This is a useful implementation in a compact recording studio where large sound intensities are generally not desired, for example for avoiding annoyance in a neighborhood of the compact recording studio. Moreover, the implementation is also useful when headphones are to be used and yet an emulation of a preferred amplifier and loudspeaker arrangement is desired, for example during musical instrument practicing.

In FIG. 5, a Volterra technique is alternatively employed as an alternative of computing the convolution **250.** The Volterra technique involves computing a general system transfer function representative of the loudspeaker arrangement **60** being driven by the amplifier **50,** for example by modeling physical processes occurring within the power amplifier **50B** and the loudspeaker arrangement **60** as elucidated in the foregoing, for example Doppler effects, inertial effects and transfer function non-linearity effects giving rise to harmonic generation in the acoustic output $S_2$. Such a Volterra technique can be implemented as a Fast Fourier Transform (FFT) mapping function whose mapping parameters are modulated by instantaneous amplitude of the signal $S_d$ when performing sound colouration synthesis. Alternatively, an Inverse Fast Four Transform (IFFT) approach can be adopted.

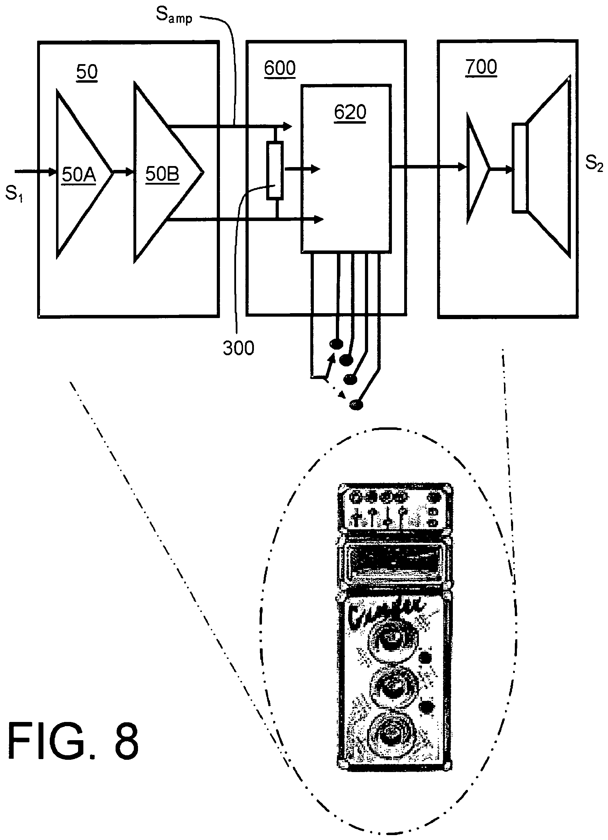

A potential commercial application of the present disclosure is illustrated in FIG. 8, wherein a valve combo amplifier includes a preamplifier **50A** and a valve power amplifier **50B** driving an input of an intermediate user-adjustable sound colouration processor **620** of an emulation unit **600.** An output of the user-adjustable sound colouration processor **620** is employed to drive a high-quality sound amplification system **700** designed to generate a low degree of sound colouration. Optionally, the user-adjustable sound colouration processor **620** is adapted to apply a compensation for colouration introduced by the sound amplification system **700** for obtaining more convincing emulations or simulations of different types of characterized amplifier and associated loudspeaker arrangements, for example Marshall, Fender, Vox, et al; "Marshall", "Fender' and "Vox" are registered trademarks (RTM). The colouration processor **620** is implemented using a digital signal processing device which has stored in its data memory one or more of the impulse responses **250** and includes computing hardware for implementing software recorded on a machine-readable data carrier for applying the impulse responses **250** to a signal output from the power amplifier **50B** to provide a signal to drive the high-quality sound amplification system **700** for enabling the combo amplifier **50A, 50B** to be employed to simulate sound colouration characteristics of other types of famous and/or popular amplifier-loudspeaker-systems.

An alternative commercial application of the present disclosure is in software products to be sold to recording studios and private musicians for use in processing musical sounds for simulating effects of given valve amplifiers and speaker arrangements by way of software applications which can be used to process recorded sound file, for example specific musical instrument tracks of a multi-track recorded composition.

For further describing the present invention, various alternative methods of measuring and computing an impulse response will now be elucidated. In a first method, following steps are executed:

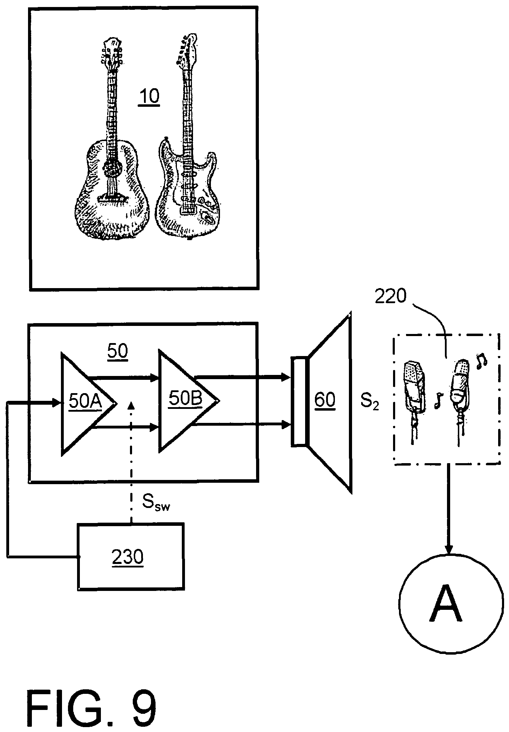

STEP 1: in FIG. 9, a sweep signal $S_{sw}$ is applied to an amplifier **50,** either at its guitar input for coupling to a guitar **10** or at a point between a power amplifier **50A** and a preamplifier **50B** of the amplifier **50.** The power amplifier **50B** is coupled to a loudspeaker arrangement **60,** for example via external cables or internally when implemented as a "combo". The sweep signal $S_{sw}$ is applied and a corresponding acoustic output $S_2$ is recorded using a microphone arrangement **220** to generate a first signal sample A. Beneficially, signals relating to several different microphone arrangement **220,** e.g. microphone placement, and loudspeaker arrangement **60** combinations are measured to generate the first signal sample A.

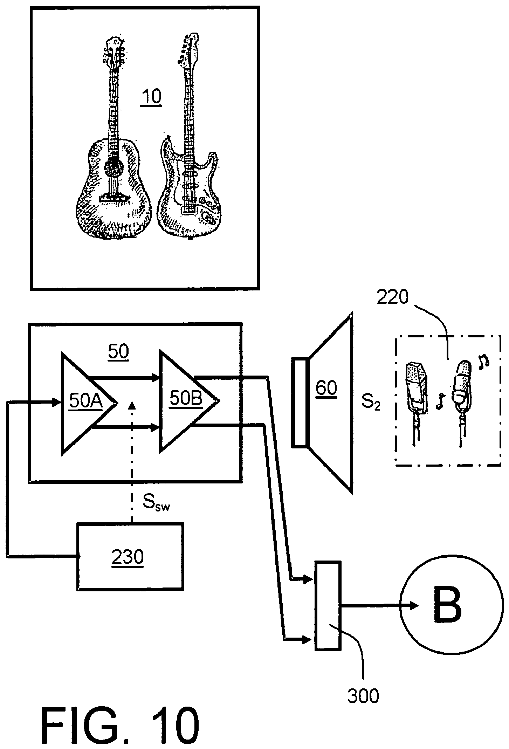

STEP 2: in FIG. 10, the amplifier **50** is connected to a dummy load 300 from which an attenuated signal is derived for providing a second signal sample B. The sweep signal $S_{sw}$ is applied as in STEP 1 to generate the second signal sample B. Beneficially, the loudspeaker arrangement **60** is disconnected in STEP 2 when generating the second signal sample B.

STEP 3: the signals samples A and B together with a representation of the corresponding sweep signal $S_{sw}$ is provided to the DSP **210** wherein the samples A and B are analysed via a processing algorithm as aforementioned to generate a corresponding impulse response **250**. The impulse response **250** is subsequently susceptible to being used to simulate in the aforesaid synthesis-phase amplification and colouration characteristics of the loudspeaker **60,** microphone arrangement **220,** and possibly the amplifier **50** in FIG. 9 and FIG. 10. The processing algorithm is beneficially implemented using for example a de-convolution operation, or FFT and/or IFFT; for example, de-convolution is beneficially executed using commercial and/or open-source convolution software. The impulse response **250** is stored in data memory, for example a data base, for subsequent use in the synthesis-phase.

The present invention is optionally adapted to provide additionally a sound copy functionality, wherein a user is able to copy guitar sounds from other guitarists or recording (LP/CD and similar) and process the copied sounds to provide them with a desired degree of sound colouration.

In a first manner of implementing the copy function, it is required that the desired distorted guitar sound from a mimicked loudspeaker and a dry undistorted and uncoloured sound signal from a guitar **10;** the user then adjusts the amplifier distortion applied to the dry undistorted and uncoloured sound signal until it resembles the desired guitar sound. Next, the user inputs the dry sound signal as the signal S, into the amplifier **50.** Then either the drive signal ($S_{amp}$) or the acoustic output (S2) is recorded and subjected to de-convolution or other signal processing operation to generate a corresponding impulse response **250** which includes a difference between the distorted target sound and the user's own distorted sound. The impulse response **250** is then stored in data memory, for example in a database, for future use by the user by way of a convolution.

In a second manner of implementing the copy function, it is required that the user inputs a self-played musical excerpt resembling an original excerpt. The self-play excerpt is then employed as the aforementioned dry signal. De-convolution is then applied between the self-played excerpt and the distorted signal to obtain a corresponding impulse response **250**. This copy functionality thereby enables a given colouration to be identified and mimicked by the user.

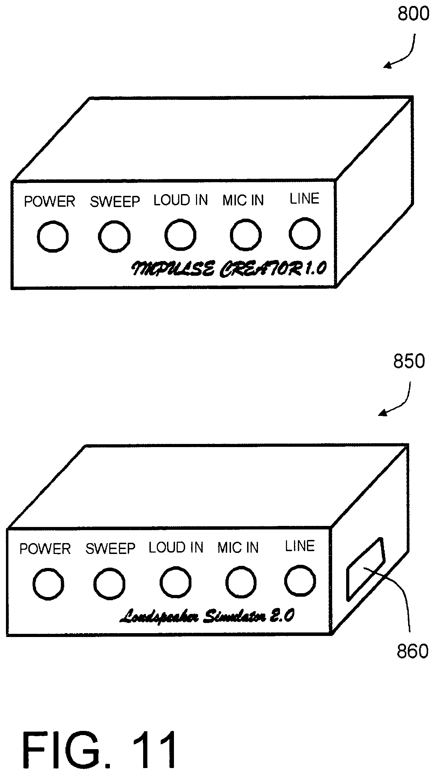

The present disclosure is capable of being implemented using devices as illustrated in FIG. 11. Optionally, two devices **800, 850** can be used for implementing aforesaid analysis-phase and simulation-phase respectively; conveniently, the devices **800, 850** are provided as user-adjustable modules, for example "ImpulseCreator 1.0" and "Loudspeaker Simulation 2.0". The devices **800, 850** include various controls for adjusting signal levels as well as connection sockets to receive and output signals. There is beneficially also provided on one or more of the devices **800, 850** and digital input/output interface. The devices **800, 850** include the aforementioned DSP **210,** together with one of more computer software products recorded on machine-readable data storage media, for example ROM and/or RAM. Optionally, at least one of the devices **800, 850** is implemented by using a standard personal computer (AppleMac, IBM Thinkpad or similar, these names being trademarks of Apple Corp. and IBM respectively) for providing computer processing power and data storage.

**Claims**

1.   A method of measuring an impulse response, including:

coupling directly to a connection between an amplifier (50) and a loudspeaker arrangement (60) and disposing a microphone arrangement (220) generating a microphone signal ($S_m$) representative of the acoustic output ($S_2$) of the loudspeaker arrangement (60) in connection with the amplifier;
placing a dummy load (300) in connection with the amplifier (50) for obtaining access to a drive signal ($S_{amp}$), wherein the amplifier is disconnected with the loudspeaker arrangement (60) while placing the dummy load in connection with the amplifier;
using a test signal generator (230) to apply a test signal ($S_{sw}$) to an input of the amplifier (50); and
receiving at a digital signal processing arrangement (DSP, 210) at least the test signal ($S_{sw}$), the drive signal ($S_{amp}$) and the microphone signal ($S_m$) representative of
the acoustic output ($S_2$) corresponding to the test signal ($S_{sw}$) and performing on these signals a signal processing operation for determining an impulse response (250) for the amplifier (50), and an impulse response (250) for the loudspeaker arrangement (60).

2.   A method as claimed in claim 1, **characterized in that** the method includes employing the test signal generator (SWP, 230) to apply a sweep frequency signals and/or a broad band test signal comprising a simultaneous plurality of signal components.

3. A method as claimed in claim 2, **characterized in that** the method includes driving the amplifier (50) at a plurality of power output levels in the acoustic output ($S_2$), and determining the impulse response (250) in respect of each of the plurality of power output in the acoustic output ($S_2$).

4. A method as claimed in any one of the preceding claims, **characterized in that** said signal processing operation is a convolution which is performed using at least one of:

(a) time-domain convolution;
(b) Fast Fourier Transform (FFT) and/or Inverse Fast Fourier Transform (IFFT); and
(c) one of more physical models describing transfer characteristics of active components present in the amplifier (50) and/or the speaker arrangement (60).

5. A method as claimed in any one of the preceding claims, **characterized in that** said method is adapted to provide a copy functionality for mimicking one or more target sound colourations, wherein a user is able to copy guitar sounds from other guitarists or recording and process the copied sounds to provide them with a desired degree of sound colouration.

6. An apparatus for use in measuring an impulse response including:

a coupling arrangement for coupling directly to a connection between an amplifier (50) and a loudspeaker arrangement (60); and
a microphone arrangement (220) for generating a microphone signal representative of the acoustic output ($S_2$) of the loudspeaker arrangement (60);
a dummy load (300) placed in connection with the amplifier (50) for obtaining access to a drive signal ($S_{amp}$), wherein the amplifier is configured to be disconnected with the loudspeaker arrangement (60) while placing the dummy load in connection with the amplifier;
a test signal generator (230) for applying a test signal ($S_{sw}$) to an input of the amplifier (50); and
a digital signal processing arrangement (DSP, 210) adapted to receive at least the test signal ($S_{sw}$), the drive signal ($S_{amp}$) and the microphone signal ($S_m$) representative of the acoustic output ($S_2$) corresponding to the test signal ($S_{sw}$) and further adapted to perform on these signals a signal processing operation for determining an impulse response (250) for the amplifier (50), and an impulse response (250) for the loudspeaker arrangement (60).

**Patentansprüche**

1. Verfahren zum Messen einer Impulsantwort, umfassend:

unmittelbares Ankoppeln an eine Verbindung zwischen einem Verstärker (50) und einer Lautsprecheranordnung (60) und Anordnen einer Mikrofonanordnung (220), die ein Mikrofonsignal ($S_m$) erzeugt, das für die akustische Ausgabe ($S_2$) der Lautsprecheranordnung (60) steht, in Verbindung mit dem Verstärker;
Platzieren einer Ersatzlast (300) in Verbindung mit dem Verstärker (50) zum Erhalten von Zugriff auf ein Ansteuersignal ($S_{amp}$), wobei der Verstärker von der Lautsprecheranordnung (60) getrennt ist, während die Ersatzlast in Verbindung mit dem Verstärker platziert wird;
Verwenden eines Testsignalgenerators (230) zum Anlegen eines Testsignals ($S_{sw}$) an einen Eingang des Verstärkers (50) und
an einer digitalen Signalverarbeitungsanordnung (DSP, 210) Empfangen von zumindest dem Testsignal ($S_{sw}$), dem Ansteuersignal ($S_{amp}$) und dem Mikrofonsignal ($S_m$), das für die akustische Ausgabe ($S_2$) steht, die dem Testsignal ($S_{sw}$) entspricht, und Vornehmen eines Signalverarbeitungsvorgangs an diesen Signalen zum Bestimmen einer Impulsantwort (250) für den Verstärker (50) und einer Impulsantwort (250) für die Lautsprecheranordnung (60).

2. Verfahren nach Anspruch 1, **dadurch gekennzeichnet, dass** das Verfahren ein Einsetzen des Testsignalgenerators (SWP, 230) zum Anlegen eines Wobbelsignals und/oder eines breitbandigen Testsignals umfasst, das eine gleichzeitige Vielzahl von Signalkomponenten umfasst.

**3.** Verfahren nach Anspruch 2, **dadurch gekennzeichnet, dass** das Verfahren ein Ansteuern des Verstärkers (50) auf einer Vielzahl von Ausgangsleistungspegeln in der akustischen Ausgabe ($S_2$) und ein Bestimmen der Impulsantwort (250) hinsichtlich jeder von der Vielzahl von Ausgangsleistungen in der akustischen Ausgabe ($S_2$) umfasst.

**4.** Verfahren nach einem der vorhergehenden Ansprüche, **dadurch gekennzeichnet, dass** der Signalverarbeitungsvorgang eine Faltung ist, die unter Verwendung von zumindest einem aus Folgenden durchgeführt wird:

    (a) Faltung im Zeitbereich;
    (b) schnelle Fourier-Transformation (FFT) und/oder inverse schnelle Fourier-Transformation (IFFT); und
    (c) ein oder mehrere physikalische Modelle, die das Übertragungsverhalten aktiver Bauteile beschreiben, die im Verstärker (50) und/oder der Lautsprecheranordnung (60) vorhanden sind.

**5.** Verfahren nach einem der vorhergehenden Ansprüche, **dadurch gekennzeichnet, dass** das Verfahren so ausgelegt ist, dass es eine Kopierfunktion zum Nachahmen von einer oder mehreren Zielklangfarben bereitstellt, wobei ein Benutzer in der Lage ist, Gitarrenklänge anderer Gitarrenspieler oder aus Aufzeichnungen zu reproduzieren und die reproduzierten Klänge zu bearbeiten, damit sie mit einer gewünschten Stärke der Klangfarbe versehen werden.

**6.** Vorrichtung zur Verwendung beim Messen einer Impulsantwort, aufweisend:

    eine Kopplungsanordnung zum unmittelbares Ankoppeln an eine Verbindung zwischen einem Verstärker (50) und einer Lautsprecheranordnung (60); und
    eine Mikrofonanordnung (220) zum Erzeugen eines Mikrofonsignals, das für die akustische Ausgabe ($S_2$) der Lautsprecheranordnung (60) steht;
    eine Ersatzlast (300), die in Verbindung mit dem Verstärker (50) platziert ist, zum Erhalten von Zugriff auf ein Ansteuersignal ($S_{amp}$), wobei der Verstärker so eingerichtet ist, dass er von der Lautsprecheranordnung (60) getrennt ist, während die Ersatzlast in Verbindung mit dem Verstärker platziert wird;
    einen Testsignalgenerator (230) zum Anlegen eines Testsignals ($S_{sw}$) an einen Eingang des Verstärkers (50) und eine digitale Signalverarbeitungsanordnung (DSP, 210), die so ausgelegt ist, dass sie zumindest das Testsignal ($S_{sw}$), das Ansteuersignal ($S_{amp}$) und das Mikrofonsignal ($S_m$) empfängt, das für die akustische Ausgabe ($S_2$) steht, die dem Testsignal ($S_{sw}$) entspricht, und ferner so ausgelegt ist, dass sie an diesen Signalen einen Signalverarbeitungsvorgang zum Bestimmen einer Impulsantwort (250) für den Verstärker (50) und einer Impulsantwort (250) für die Lautsprecheranordnung (60) vornimmt.

## Revendications

**1.** Procédé de mesure de la réponse à une impulsion, comprenant :

    le couplage direct à une connexion entre un amplificateur (50) et un dispositif de haut-parleur (60) et la disposition d'un dispositif de microphone (220) générant un signal de microphone ($S_m$) représentatif de la sortie acoustique ($S_2$) du dispositif de haut-parleur (60) en connexion avec l'amplificateur ;
    le placement d'une charge factice (300) en connexion avec l'amplificateur (50) afin d'obtenir l'accès à un signal de commande ($S_{amp}$), l'amplificateur étant déconnecté du dispositif de haut-parleur (60) lorsque la charge factice est placée en connexion avec l'amplificateur ;
    l'utilisation d'un générateur de signal de test (230) afin d'appliquer un signal de test ($S_{sw}$) à une entrée de l'amplificateur (50) ; et
    la réception par un dispositif de traitement numérique du signal (DSP, 210) d'au moins le signal de test ($S_{sw}$), le signal de commande ($S_{amp}$) et le signal de microphone ($S_m$) représentatif de la sortie acoustique ($S_2$) correspondant au signal de test ($S_{sw}$) et l'exécution sur ces signaux d'une opération de traitement du signal afin de déterminer la réponse (250) à une impulsion de l'amplificateur (50), et la réponse (250) à une impulsion du dispositif de haut-parleur (60).

**2.** Procédé selon la revendication 1, **caractérisé en ce que** le procédé comporte l'utilisation du générateur de signal de test (SWP, 230) pour appliquer un des signaux de fréquence de balayage et/ou un signal de test large bande comprenant une pluralité simultanée de composants du signal.

**3.** Procédé selon la revendication 2, **caractérisé en ce que** le procédé comporte la commande de l'amplificateur (50) à une pluralité de niveaux de puissance de sortie dans la sortie acoustique ($S_2$), et la détermination de la réponse (250) à l'impulsion pour chacun de la pluralité de puissance de sortie dans la sortie acoustique ($S_2$).

4. Procédé selon l'une quelconque des revendications précédentes, **caractérisé en ce que** ladite opération de traitement du signal est une convolution effectuée avec au moins l'un des éléments suivants :

(a) convolution dans le domaine temporel ;
(b) transformation de Fourier rapide (FFT) et/ou transformation de Fourier rapide inverse (IFFT) ; et
(c) un ou plusieurs modèles physiques décrivant les caractéristiques de transfert des composants actifs présents dans l'amplificateur (50) et/ou le dispositif de haut-parleur (60).

5. Procédé selon l'une quelconque des revendications précédentes, **caractérisé en ce que** ledit procédé est conçu pour fournir une fonctionnalité de copie qui imite une ou plusieurs colorations sonores visées, un utilisateur étant capable de copier des sons de guitare d'autres guitaristes ou d'enregistrer et de traiter les sons copiés afin de leur donner un degré souhaité de coloration sonore.

6. Appareil destiné à être utilisé dans la mesure de la réponse à une impulsion, comportant :

un dispositif de couplage destiné à coupler directement à une connexion entre un amplificateur (50) et un dispositif de haut-parleur (60) ; et
un dispositif de microphone (220) destiné à générer un signal de microphone représentatif de la sortie acoustique ($S_2$) du dispositif de haut-parleur (60) ;
une charge factice (300) placée en connexion avec l'amplificateur (50) afin d'obtenir l'accès à un signal de commande ($S_{amp}$), l'amplificateur étant conçu pour être déconnecté du dispositif de haut-parleur (60) lorsque la charge factice est placée en connexion avec l'amplificateur ;
un générateur de signal de test (230) destiné à appliquer un signal de test ($S_{sw}$) à une entrée de l'amplificateur (50) ; et
un dispositif de traitement numérique du signal (DSP, 210) conçu pour recevoir au moins le signal de test ($S_{sw}$), le signal de commande ($S_{amp}$) et le signal de microphone ($S_m$) représentatif de la sortie acoustique ($S_2$) correspondant au signal de test ($S_{sw}$) et conçu en outre pour exécuter sur ces signaux une opération de traitement du signal afin de déterminer la réponse (250) à une impulsion de l'amplificateur (50), et la réponse (250) à une impulsion du dispositif de haut-parleur (60).

FIG. 1

FIG. 2

FIG. 3

FIG. 4

FIG. 5

FIG. 6

FIG. 7

FIG. 8

# FIG. 9

FIG. 10

800

POWER SWEEP LOUD IN MIC IN LINE

*IMPULSE CREATOR 1.0*

850

POWER SWEEP LOUD IN MIC IN LINE

*Loudspeaker Simulator 2.0*

860

# FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 0028521 A
- GB 9903753 W
- CN 101426169 A